# EUROPÄISCHE PATENTANMELDUNG

(11) **EP 3 957 768 A1**
(43) Veröffentlichungstag der Anmeldung: **23.02.2022**
(21) Anmeldenummer: 21191592.1
(22) Anmeldetag: 17.08.2021
(51) Int. Cl.: C23C 16/02, C23C 16/26, C23C 16/56

(54) **VERFAHREN ZUR HERSTELLUNG EINER HARTSTOFFSCHICHT AUF EINER METALLOBERFLÄCHE**

(30) Priorität: 18.08.2020 AT 506942020
(71) Anmelder: Rübig Gesellschaft m.b.H & Co. KG, 4600 Wels (AT)
(72) Erfinder: Rübig, Bernd, 4600 Wels (AT)
(74) Vertreter: Burger, Hannes

(57) **Zusammenfassung**

Die Erfindung betrifft ein Verfahren zur Herstellung einer Hartstoffschicht (3) mit einer Härte gemäß DIN EN ISO 14577 von mindestens 3 GPa auf einer Metalloberfläche (2) eines Substrats mittels Gasphasenabscheidung, wobei die Metalloberfläche (2) vor der Abscheidung der Hartstoffschicht (3) zur Ausbildung einer Oberflächenstruktur (8) oberflächenbehandelt wird, sodass die Oberfläche nach der Oberflächenbehandlung eine Oberflächenrauigkeit nach DIN EN ISO 4287:2010-07 mit einem arithmetischen Mittenrauwert Ra zwischen 0,5 µm und 50 µm aufweist, wobei die Hartstoffschicht (3) mit einer Schichtdicke (9) hergestellt wird, die um mindestens 2,5 % größer ist als Ra der Metalloberfläche (2) und die Hartstoffschicht (3) nach der Abscheidung zur Reduktion der Oberflächenrauigkeit oberflächenbehandelt wird.

## Beschreibung

Die Erfindung betrifft ein Verfahren zur Herstellung einer Hartstoffschicht mit einer Härte gemäß DIN EN ISO 14577 von mindestens 3 GPa auf einer Metalloberfläche eines Substrats mittels Gasphasenabscheidung, wobei die Metalloberfläche vor der Abscheidung der Hartstoffschicht zur Ausbildung einer Oberflächenstruktur oberflächenbehandelt wird, sodass die Oberfläche nach der Oberflächenbehandlung eine Oberflächenrauigkeit nach DIN EN ISO 4287:2010-07 mit einem arithmetischen Mittenrauwert Ra zwischen 0,5 µm und 50 µm aufweist.

Weiter betrifft die Erfindung einen Gegenstand mit einer tribologische beanspruchten Oberfläche, die durch eine Hartstoffschicht mit einer Härte gemäß DIN EN ISO 14577 von mindestens 3 GPa gebildet ist, wobei die Hartstoffschicht auf einer Metalloberfläche des Gegenstandes angeordnet ist, die eine Oberflächenrauigkeit nach DIN EN ISO 4287:2010-07 mit einem arithmetischen Mittenrauwert Ra zwischen 0,5 µm und 50 µm aufweist.

Zudem betrifft die Erfindung die Verwendung eines gemäß einem Verfahren nach der Erfindung hergestellten Gegenstandes.

Aus dem Stand der Technik ist bekannt, in tribologischen beanspruchten Oberflächen mit verbessertem Ölrückhaltevermögen vorzusehen, um damit Schmieröl für den Betrieb in der Oberfläche einlagern zu können. Häufig anzutreffen sind dabei Werkstücke aus Sinterwerkstoffen, da diese Werkstücke relativ einfach mit einer porösen Struktur der Oberfläche herstellbar sind.

Im Stand der Technik sind aber auch schon Werkstücke mit Hartstoffschichten beschrieben worden, bei denen die Hartstoffschichten ein verbessertes Ölrückhaltevermögen aufweisen. So beschreibt beispielsweise die DE 100 60 931 A1 ein Verfahren zum Formen von Oberflächenölreservoirs auf einem duktilen Eisensubstrat, dass folgendes aufweist: Vorbereitung eines Eisensubstrates; Abrasives Bestrahlen bzw. Sandstrahlen des Eisensubstrates, auf dem eine Beschichtung abzulagern ist; Plasmaätzen des Eisensubstrates, auf dem die Beschichtung abzulagern ist; und Ablagerung einer Beschichtung auf dem Substrat durch einen Ablagerungs- bzw. Depositionsprozess.

Die DE 10 2011 087 667 A1 beschreibt ein Verfahren, bei dem eine DLC Schicht auf einem Bauteil mit einem Hartstoff gestrahlt wird. Die DLC-Schicht ist dünn ausgeführt mit einer Schichtdicke nur ca. 1 µm bis 7 µm. Diese Oberflächenbehandlung bewirkt eine Veränderung der Oberflächenstruktur, die Rauheit der technischen Oberfläche wird durch das Brechen der Rauheitsspitzen reduziert und der Traganteil der Oberfläche wird somit erhöht. Damit werden die lokalen Flächenpressungen kleiner und die Lebensdauer der DLC-Schicht verlängert. Es wird nämlich als Nachteil bei dem Verfahren nach der DE 100 60 931 A1 angesehen, dass die Oberfläche aufgrund der Oberflächen-Ölreservoirs eine relativ große Rauheit und somit wenig tragende Anteile aufweist.

Die DE 10 2016 200 367 B3 beschreibt ein Verfahren zum Herstellen einer dünnen Schicht aus porösem diamantähnlichem Kohlenstoff (DLC) mit plasmaunterstützter chemischer Gasphasenabscheidung, bei dem ein zu beschichtendes Werkstück in einem Rezipienten bereitgestellt und anschließend auf einer zu beschichtenden Oberfläche des Werkstücks eine dünne Schicht aus porösem DLC durch mehrfach wiederholtes Ausführen der folgenden Schritte deponiert wird: Einleiten eines kohlenstoffhaltigen Precursor-Gases in den Rezipienten und Abscheiden einer DLC-Schicht auf der zu beschichtenden Oberfläche des Werkstücks bei einem Arbeitsdruck von 20×10⁻³ mbar bis 30×10⁻³ mbar und einer BIAS-Spannung von -250 V bis -150 V, anschließendes Einleiten eines Rückätz-Gases in den Rezipienten und Rückätzen der auf der Oberfläche des Werkstücks deponierten DLC-Schicht bei einem Arbeitsdruck von 200×10⁻³ mbar bis 300×10⁻³ mbar und einer BIAS-Spannung von -430 V bis -330 V. Aufgrund der mehrmaligen Wiederholung der Verfahrensschritte ist diese Verfahren relativ aufwändig.

Der vorliegenden Erfindung liegt die Aufgabe zu Grunde, einen mit einer Hartstoffschicht versehenen tribologisch beanspruchten Gegenstand zur Verfügung zu stellen, dessen Hartstoffschicht die Oberfläche eines Gleitpartners möglichst wenig beeinträchtigt.

Die Aufgabe der Erfindung wird bei dem eingangs genannten Verfahren dadurch gelöst, dass die Hartstoffschicht mit einer Schichtdicke hergestellt wird, die um mindestens 2,5 % größer ist als Ra der Metalloberfläche und die Hartstoffschicht nach der Abscheidung zur Reduktion der Oberflächenrauigkeit oberflächenbehandelt wird.

Weiter wird die Aufgabe der Erfindung mit dem eingangs genannten Gegenstand gelöst, bei dem die Hartstoffschicht eine Schichtdicke aufweist, die um mindestens 2 % größer ist als Ra, und die Hartstoffschicht ein Oberflächenrauigkeit zur Ausbildung von Schmiermitteltaschen und zur Aufnahme von Partikel aus dem Abrieb aufweist.

Zudem wird die Aufgabe der Erfindung durch die eingangs genannte Verwendung gemäß einem erfindungsgemäßen Verfahren hergestellten Gegenstandes in einer tribologisch beanspruchten Reibpaarung gelöst.

Von Vorteil ist dabei, dass die Hartstoffschicht die Oberflächenrauigkeit des Substrats annährend nachbildet und damit die Taschen für das Schmiermittel und den Abrieb (auch von größeren Partikeln) ohne weitere Bearbeitung ausbildet, durch die Nachbearbeitung aber von Rauheitsspitzen befreit wird bzw. ist, womit Abrieb der Oberfläche des Gleitpartners im Betrieb des beschichteten Gegenstandes deutlich reduziert werden kann. Im Zuge der Evaluierung hat sich gezeigt, dass das Einmalige Auftragen eines Schmiermittels ausreichend ist, sodass also die tribologisch beanspruchte Hartstoffschicht wartungsfrei ist. Da die Hartstoffschicht die gewünschten mechanischen Eigenschaften aufweist, kann aus Substrat auch ein weicherer Werkstoff, wie beispielsweise ein weicherer Stahl, anstelle eine Werkzeugstahls eingesetzt werden. Aufgrund der Schichtdicke der Hartstoffschicht kann auch die nachträgliche Bearbeitung dieser vereinfacht werden. Die relativ große Schichtdicke ermöglicht auch einen besseren Korrosionsschutz des darunter liegenden Substrats.

Zur weiteren Verbesserung dieser Effekte kann nach einer Ausführungsvariante der Erfindung vorgesehen sein, dass die Metalloberfläche vor der Abscheidung der Hartstoffschicht mit einer gemittelten Rautiefe Rz nach DIN EN ISO 4287:2010-07 zwischen 0,5 µm und 20 µm hergestellt wird und die Hartstoffschicht mit einer Schichtdicke hergestellt wird, die um mindestens 5 % größer ist als Rz der Metalloberfläche

Zur verfahrenstechnisch einfacheren Erreichung der voranstehend genannten Eigenschaften des Gegenstandes kann nach einer weiteren Ausführungsvariante der Erfindung vorgesehen sein, dass die Hartstoffschicht mit einer Schichtdicke von mindestens 10 µm hergestellt wird bzw. diese aufweist. Insbesondere der Korrosionsschutz des Substrats kann damit ebenfalls verbessert werden.

Andererseits hat eine Schichtdicke der Hartstoffschicht von mehr als 200 µm keine wesentlichen Verbesserungen der Eigenschaften des hartstoffbeschichteten Gegenstandes bewirkt. Die durch die längere Verfahrenszeit und die größere Schichtdicke der Hartstoffschicht verursachten Kosten stehen in keinem eine weitere Erhöhung der Schichtdicke rechtfertigenden Verhältnis. Aus diesem Grund ist nach eine weiteren Ausführungsvariante der Erfindung vorgesehen, dass die Hartstoffschicht mit einer Schichtdicke von maximal 200 µm hergestellt wird bzw. dass die Hartstoffschicht maximal diese Schichtdicke aufweist.

Gemäß einer bevorzugten Ausführungsvariante der Erfindung kann vorgesehen sein, dass als Hartstoffschicht eine DLC Schicht, insbesondere eine a:C-H-Si - DLC Schicht, hergestellt wird, da damit auch das Aufschweißen des die Hartstoffschicht aufweisenden Gegenstandes auf den Gleitpartner während des Stillstandes und somit ein daraus resultierenden adhäsiver Verschleiß besser vermieden werden kann.

Prinzipiell kann die Oberflächenbehandlung der Hartstoffschicht nach deren Abscheidung auf der Metalloberfläche mit allen geeigneten Verfahren durchgeführt werden. Nach einer Ausführungsvariante der Erfindung wird jedoch als Oberflächenbehandlung der Hartstoffschicht nach der Abscheidung ein Schleifen, Polieren oder Strahlen durchgeführt, da damit die Rauigkeitsspitzen einfach und rasch ohne große thermische Belastung der Hartstoffschicht entfernt werden können.

Eine bessere Einlagerbarkeit auch für große Partikel aus dem Abrieb während des Betriebes des Gegenstandes kann mit einer Ausführungsvariante der Erfindung erreicht werden, wenn die Hartstoffschicht durch die Oberflächenbehandlung mit einem arithmetischen Mittenrauwert Ra nach DIN EN ISO 4287:2010-07 zwischen 0,5 µm und 50 µm und/oder einer gemittelten Rautiefe Rz nach DIN EN ISO 4287:2010-07 zwischen 0,5 µm und 50 µm hergestellt wird bzw. die Hartstoffschicht diese Oberflächenbeschaffenheit aufweist.

Um das Substrat weitestgehend vor einer thermischen Belastung während der Abscheidung der Hartstoffschicht zu schützen, kann nach einer weiteren Ausführungsvariante der Erfindung vorgesehen sein, dass die Abscheidung der Hartstoffschicht mittels eines PACVD-Verfahrens (Plasma Assisted Chemical Vapor Deposition) durchgeführt wird.

Zur Verbesserung der Haftung der Hartstoffschicht auf der Metalloberfläche kann nach einer anderen Ausführungsvariante vorgesehen sein, dass das Substrat vor der Abscheidung der Hartstoffschicht nitriert wird.

Dabei ist von Vorteil, wenn die Nitrierung des Substrats bis zu einer Schichtdicke zwischen 10 µm und 1000 µm durchgeführt wird, gemessen von der Metalloberfläche beginnend.

Obwohl die Erfindung generell für tribologisch beanspruchte Gegenstände (im Maschinenbau) mit einer Hartstoffschicht anwendbar ist, hat sich die Ausbildung der Hartstoffschicht entsprechend der Erfindung auf einem Zahnrad, einem Kolbenring, einer Nockenwelle, einem Bolzen, einer Achse, einer Kolbenstange, einem Lager, wie insbesondere einem Wälzlager, als besonders vorteilhaft erwiesen.

Gemäß einer anderen Ausführungsvariante der Erfindung kann vorgesehen sein, dass die Hartstoffschicht einlagig ausgebildet ist, womit Korrosionserscheinungen ebenfalls besser vermieden werden können.

Zum besseren Verständnis der Erfindung wird diese anhand der nachfolgenden Figuren näher erläutert.

Es zeigen jeweils in vereinfachter, schematischer Darstellung:
- Fig. 1: einen Ausschnitt aus einem mit einer Hartstoffschicht versehenen Gegenstand im Querschnitt;
- Fig. 2: einen Ausschnitt aus einer Anlage zur Herstellung des mit der Hartstoffschicht versehenen Gegenstandes.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

Sämtliche in dieser Beschreibung angeführten Zitate von Normen beziehen sich jeweils auf die am Anmeldetag gegenständlicher Anmeldung letztgültige Fassung, sofern nicht explizit etwas anderes angegeben ist.

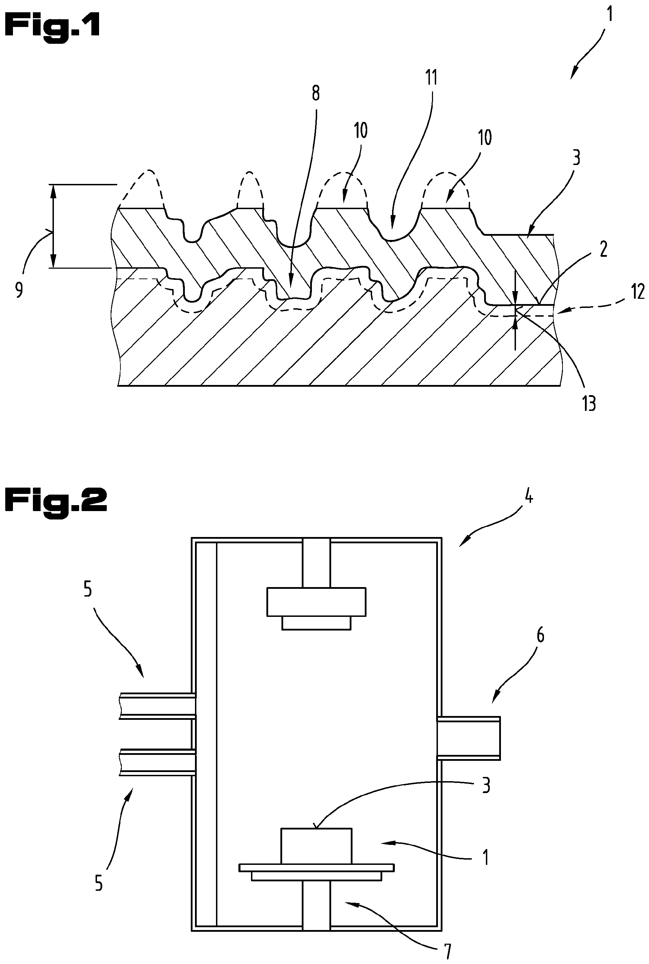

In Fig. 1 ist ein Ausschnitt aus einem Gegenstand 1, auch als Werkstück bezeichenbar, im Querschnitt dargestellt. Der Gegenstand 1 weist eine Metalloberfläche 2 auf, auf der eine Hartstoffschicht 3 angeordnet ist, insbesondere unmittelbar auf der Metalloberfläche.

Der Gegenstand 1 ist zumindest im Bereich der Hartstoffschicht 3 aus Metall bzw. umfasst in diesem Bereich ein Metall, kann jedoch auch zur Gänze aus einem Metall sein. Der metallische Bestandteil des Gegenstandes 1 kann beispielsweise eisenbasiert sein, z.B. aus einem Stahl oder Stahlguss oder Gusseisen, bestehen. Es ist jedoch aus möglich, dass der Gegenstand 1 auch ein anderes Metall im Bereich der Hartstoffschicht aufweist oder daraus besteht, beispielsweise kupferbasiert ist, beispielsweise aus Bronze oder Messing besteht, oder aus Aluminium oder Titan besteht, oder auf Nickelbasis gebildet ist.

Der Ausdruck eisenbasiert bedeutet, dass Eisen den größten Anteil an dem Metall in dem genannten Bereich aufweist. Entsprechendes gilt für die anderen Metallbasiswerkstoffe.

Die Hartstoffschicht 3 kann z.B. TiN, TiBN, TIAlN, etc., sein bzw. diese umfassen. In der bevorzugten Ausführungsvariante der Erfindung ist die Hartstoffschicht 3 jedoch eine DLC-Schicht (DLC = Diamond Like Carbon) Schicht.

Da DLC-Schichten an sich bekannt sind, sei auf den einschlägigen Stand der Technik dazu verwiesen. Der Begriff "DLC-Schicht" wird im Sinne der ISO 20523:2017 verstanden. Demnach bestehen wasserstofffreie amorphe Kohlenstoffschichten (a-C) überwiegend aus sp2-hybridisierten Bindungen und Tetraedrische wasserstofffreie amorphe Kohlenstoffschichten (ta-C), überwiegend aus sp3-hybridisierten Bindungen. Daneben gibt es metallhaltige wasserstofffreie amorphe Kohlenstoffschichten (a-C:Me), wasserstoffhaltige amorphe Kohlenstoffschichten (a-C:H; H-Anteil > 35 %), tetraedrische wasserstoffhaltige amorphe Kohlenstoffschichten (ta-C:H; H-Anteil >25 %) mit überwiegend sp3-hybridisierten Kohlenstoffatomen, metallhaltige wasserstoffhaltige amorphe Kohlenstoffschichten (a-C:H:Me) und modifizierte wasserstoffhaltige amorphe Kohlenstoffschichten (a-C:H:X; Dotierung mit Elementen wie Si, O, N, F und B).

Aus den genannten DLC-Werkstoffen werden vorzugsweise a-C:H:Me Schichten mit einem Anteil an Metall zwischen 1 Gew.-% und 50 Gew.-%, und a-C:H:X mit einem Anteil an X zwischen 1 Gew.-% und 50 Gew.-% eingesetzt, da damit der Reibkoeffizient der Schicht reduziert und die Haftung am Substrat verbessert werden können. Als Metall kann z.B. W, Ti, etc., eingesetzt werden.

Besonders bevorzugt ist die a:C-H-Si - DLC Schicht mit einem Si-anteil zwischen 10 Gew.-% und 45 Gew.-%.

Die Hartstoffschicht 3 hat eine Härte nach DIN EN ISO 14577 von mindestens 3 GPa (10mN/20s). Insbesondere hat die Hartstoffschicht 3 eine Härte nach DIN EN ISO 14577 zwischen 3 GPa (10mN/20s) und 80 GPa (10mN/20s), vorzugsweise eine Härte nach DIN EN ISO 14577 zwischen 10 GPa (10mN/20s) und 30 GPa (10mN/20s).

Die Herstellung des Gegenstandes 1 mit der Hartstoffschicht 3 erfolgt mittels Gasphasenabscheidung. Dazu wird ein Substrat mit der zu beschichtenden Metalloberfläche 3 in eine Abscheidekammer 4 einer Anlage zur Gasphasenabscheidung gegeben. Die Abscheidekammer 4 ist beispielhaft und stark vereinfacht in Fig. 2 dargestellt.

Da derartige Anlagen an sich aus dem Stand der Technik bekannt sind, sei zur Vermeidung von Wiederholungen zu weiteren Einzelheiten dazu auf diesen Stand der Technik verwiesen.

Die Abscheidung der Hartstoffschicht 3 kann beispielsweise mittels eines PVD-Verfahrens (PVD = Physical Vapor Deposition) erfolgen. Beispielsweise kann die Hartstoffschicht 3 durch Sputtern (Kathodenzerstäubung) hergestellt werden, z.B. mittels Magnetronsputtern, reaktives Sputter, Ionenstrahlsputtern, etc. hergestellt. Es können aber auch andere Sputtertechniken eingesetzt werden. Weiter können auch andere PVD-Verfahren eingesetzt werden, wie beispielsweise das Elektronenstrahlverdampfen, das (gepulste) Laserstrahlverdampfen, das Lichtbogenverdampfen, das Ionenplattieren etc.

Nach dem Sputterverfahren können z.B. Hartstoffschichten 3 z.B. aus Aluminium, Chrom, Kohlenstoff, Wolfram, Titan, etc., hergestellt werden. Dazu kann in der Abscheidekammer 4 zumindest ein zu zerstäubendes Target angeordnet werden, wie dies an sich bekannt ist.

Generell können zur Durchführung des Verfahrens folgende Parameter angewandt werden.
Mögliche Gase: H₂, N₂, Ar, CH₄, C₂H₂
Substrat-Temperatur: 600 °C - 1000 °C,
Druck in der Abscheidekammer: 15 hPa - 950 hPa (1 mbar - 1 bar)
Gasdurchfluss: 5 l/h bis 100 l/h

In der bevorzugten Ausführungsvariante der Erfindung, insbesondere wenn als Hartstoffschicht 3 eine DLC-Schicht hergestellt wird, erfolgt deren Herstellung mittels einer chemischen Gasphasenabscheidung (CVD = Chemical Vapor Deposition), insbesondere mittels eines PACVD-Verfahrens (PACVD = Plasma Assisted Chemical Vapor Deposition).

Generell können zur Durchführung des CVD-Verfahrens folgende Parameter angewandt werden.
Substrat-Temperatur: 150 °C - 700 °C,
Druck in der Abscheidekammer:0,001 hPa - 6 hPa (1.10⁻³ mbar - 6 mbar)
Gasdurchfluss: 1 l/h bis 500 l/h

Generell können zur Durchführung des PACVD-Verfahrens folgende Parameter angewandt werden.
Substrat-Temperatur: 150 °C - 600 °C,
Druck in der Abscheidekammer:0,001 hPa - 10 hPa (1.10⁻³ mbar - 10 mbar)
Gasdurchfluss: 1 l/h bis 500 l/h

Bei sämtlichen Verfahren kann das Substrat vor der Abscheidung der Hartstoffschicht 3 mit herkömmlichen Verfahren gereinigt werden, wie z.B. mit einem Lösemittel bzw. mittels wässrige Reinigung, mittels Reinigungstechnologie mit Ultraschall, abgestimmt auf die Verunreinigung, händische Reinigung mittels Alkohol bzw. diversen Reinigungsmittel. Es soll damit eine Oberfläche bereitgestellt werden, die frei von Verunreinigungen bzw. Oxidationsprodukten (Oxiden) ist. Weiter kann die zu beschichtende Oberfläche aktiviert werden, wie dies ebenfalls bekannt ist.

Die Abscheidekammer 4 weist auch zumindest eine Abfuhrleitung 6 zur Evakuierung der Kammer auf. Weiter kann in der Abscheidekammer 4 zumindest ein Substrathalter 7 angeordnet sein, der gegebenenfalls drehbar ausgeführt ist.

Für die Durchführung eines CVD-Verfahrens, insbesondere PACVD-Verfahrens, kann die Abscheidekammer 4 ein oder mehrere Zufuhrleitungen 5 für ein Spülgas und/oder für gasförmige Precurser, aus denen die DLC-Schicht gebildet wird, wie z.B. CH4, C2H2, HDMSO (Hexamethyldisiloxan), Tetramethylsilan (TMS), Hexan, etc.

Natürlich sind derartige Beschichtungsanlagen deutlich komplexer als gezeigt ausgeführt. Da diese aber bekannt sind, erübrigen sich weitere Ausführungen dazu. Beispielsweise kann eine von der Anmelderin stammende Beschichtungsanlage, beispielsweise eine Plasmanitrieranlage EV, verwendet werden. Diese kann gegebenenfalls z.B. hinsichtlich der Elektroden, der Gasverteilsysteme, etc., angepasst werden

Zur Herstellung des Gegenstandes 1 ist vorgesehen, dass dessen zu beschichtenden Metalloberfläche 2 oberflächenbehandelt wird, um damit auf dieser Metalloberfläche 2 eine Oberflächenstruktur 8, wie sie beispielhaft in Fig. 1 dargestellt ist, zu erzeugen. Dazu wird die Oberflächenstruktur so ausgeführt, dass die Metalloberfläche 2 nach der Oberflächenbehandlung eine Oberflächenrauigkeit nach DIN EN ISO 4287:2010-07 bzw. DIN EN ISO 4288:1998 mit einem arithmetischen Mittenrauwert Ra zwischen 0,5 µm und 50 µm aufweist, insbesondere zwischen 0,5 µm und 20 µm bzw. zwischen 0,8 µm und 20 µm, aufweist.

Die Oberflächenstruktur 8 kann dabei in Form eines regelmäßigen oder unregelmäßigen Muster hergestellt werden. Beispielsweise kann die Metalloberfläche 2 spanend bearbeitet werden, z.B. geschliffen, gehont, etc., oder geätzt werden, womit unregelmäßige Oberflächenstrukturen erzeugt werden. Die Ausbildung von regelmäßigen Oberflächenstrukturen 8 kann beispielsweise mittels eines Lasers erfolgen, indem z.B. auf der Metalloberfläche 2 zueinander parallele Rillen, oder Vertiefungen, etc., erzeugt werden. Generell werden vorzugsweise periodische Strukturen erzeugt, also Strukturen, die zumindest ein wiederkehrendes Strukturelement aufweisen.

Auf dieser Oberflächenstruktur 8 wird in weiterer Folge die Hartstoffschicht 3 erzeugt, insbesondere mit einem der voranstehend genannten Verfahren. Wie aus Fig. 1 zu ersehen ist (teilweise strichliert), bildet die Hartstoffschicht 3 die Oberflächenstruktur der Metalloberfläche 2 zumindest annähernd nach. Es ist nun vorgesehen, dass eine Schichtdicke 9 der Hartstoffschicht 3 nach der Abscheidung um mindestens 2,5 % größer ist als der arithmetischen Mittenrauwert Ra der Oberflächenstruktur 8 der Metalloberfläche 2. Mit anderen Worten ausgedrückt ist die Schichtdicke 9 der Hartstoffschicht 3 an keiner Stelle kleiner als 102,5 % des arithmetischen Mittenrauwerts Ra der Oberflächenstruktur 8 der Metalloberfläche 2. Insbesondere kann die Hartstoffschicht 3 eine Schichtdicke 9 aufweisen, die zwischen 2,5 % und 50 % bzw. zwischen 5 % und 50 % bzw. zwischen 10 % und 50 % (jeweils nach der Abscheidung) größer ist als der arithmetischen Mittenrauwert Ra der Oberflächenstruktur 8 der Metalloberfläche 2.

Die Schichtdicke 9 der Hartstoffschicht 3 wird senkrecht auf die Metalloberfläche 2 gemessen.

Diese Schichtdicke 9 wird durch entsprechend langes Beschichten der Metalloberfläche 2 erreicht.

Gemäß Ausführungsvarianten der Erfindung kann vorgesehen sein, dass die Hartstoffschicht 3 eine Schichtdicke 9 von mindestens 5 µm, insbesondere mindestens 10 µm, beispielsweise mindestens 15 µm, und/oder von maximal 200 µm, insbesondere maximal 50 µm, aufweist.

Nach einer weiteren Ausführungsvariante der Erfindung kann vorgesehen werden, dass die Metalloberfläche 2 vor der Abscheidung der Hartstoffschicht 3 mit einer gemittelten Rautiefe Rz nach DIN EN ISO 4287:2010-07 bzw. DIN EN ISO 4288:1998 zwischen 0,5 µm und 20 µm hergestellt wird und die Hartstoffschicht 3 mit einer Schichtdicke 9 hergestellt wird, die um mindestens 5 % größer ist als die gemittelte Rautiefe Rz der Metalloberfläche 2.

Nach der Abscheidung der Hartstoffschicht 3 auf der Metalloberfläche 2 wird diese zur Reduktion der Oberflächenrauigkeit oberflächenbehandelt. Generell kann diese Oberflächenbehandlung mit allen hierzu bekannten (spanenden) Verfahren durchgeführt werden, wie z.B. durch Läppen, Honen, usw. Bevorzugt wird dazu die Oberfläche der Hartstoffschicht 3 geschliffen, poliert oder gestrahlt. Durch diese Oberflächenbehandlung werden Defekte an der Hartstoffschichtoberfläche und Rauhigkeitsspitzen der Hartstoffschicht 3 abgearbeitet. Es entsteht eine Oberflächenstruktur der Hartstoffschicht 3 die Plateaus 10 aufweist, wie dies in Fig. 1 dargestellt ist. Gleichzeitig bleiben aber Täler 11 bzw. Vertiefungen erhalten, in denen ein Schmierstoff eingelagert werden kann. Es ist dabei ein einmaliger Auftrag des Schmiermittels ausreichend, sodass die tribologisch beanspruchte Oberfläche der Hartstoffschicht 3 wartungsfrei ist. Die Täler 11 bzw. Vertiefungen dienen auch der Einlagerung von Partikeln aus dem Abrieb im Betrieb des Gegenstandes 1.

Zur weiteren Verbesserung dieser Eigenschaften kann nach einer weiteren Ausführungsvariante der Erfindung vorgesehen sein, dass die Hartstoffschicht 3 durch die Oberflächenbehandlung mit einem arithmetischen Mittenrauwert Ra nach DIN EN ISO 4287:2010-07 bzw. DIN EN ISO 4288:1998 zwischen 0,5 µm und 50 µm und/oder einer gemittelten Rautiefe Rz nach DIN EN ISO 4287:2010-07 bzw. DIN EN ISO 4288:1998 zwischen 0,5 µm und 50 µm hergestellt wird.

Bevorzugt wird die Oberflächenbehandlung der Hartstoffschicht 3 nur maximal so weit ausgeführt, dass die Schichtdicke 9 der Hartstoffschicht 3 an keiner Stelle kleiner ist, als 5 % des arithmetischen Mittenrauwerts Ra der Oberflächenstruktur 8 der Metalloberfläche 2, die Metalloberfläche 2 also durch die Nachbearbeitung der Hartstoffschicht 3 nicht freigelegt wird.

Gemäß einer Ausführungsvariante der Erfindung kann vorgesehen sein, dass das Substrat vor der Abscheidung der Hartstoffschicht 3 nitriert wird, um damit eine bessere Haftung der Hartstoffschicht 3 auf dem Substrat zu erreichen. Dies kann beispielsweise durch Plasmanitrieren unter Anwendung folgender Parameter erfolgen:
Temperatur: 375 °C - 600 °C,
Druck in der Abscheidekammer:0,1 hPa - 8 hPa (0,1 mbar - 8 mbar)
Gasdurchfluss: 1 l/h bis 500 l/h

Die Oberflächennitrierung führt zu einer nitrierten Substratschicht 12, wie dies in Fig. 1 strichliert angedeutet ist. Die Oberflächennitrierung kann in derselben Abscheidekammer 4 durchgeführt werden, in der auch die Abscheidung der Hartstoffschicht 3 erfolgt.

Die Nitrierung der Oberfläche des Substrats für den Gegenstand 1 kann gemäß einer Ausführungsvariante bis zu einer Schichtdicke 13 zwischen 10 µm und 1000 µm durchgeführt werden, gemessen von der Metalloberfläche 2 beginnend.

Obwohl es prinzipiell möglich ist, die Hartstoffschicht 3 mehrlagig auszuführen, kann gemäß einer bevorzugten Ausführungsvariante vorgesehen sein, dass die Hartstoffschicht 3 einlagig ausgebildet ist.

Generell kann der Gegenstand 1 ein tribologisch beanspruchter Gegenstand 1 sein. Bevorzugt ist der Gegenstand ein Zahnrad, ein Kolbenring, eine Nockenwelle, ein Bolzen, eine Achse, eine Kolbenstange, ein Lager, wie insbesondere ein Wälzlager.

Die Hartstoffschicht 3 kann als Hartchromersatz dienen.

Zur Evaluierung der Eigenschaften der Hartstoffschicht 3 wurden folgende Beispiele durchgeführt.

Auf einem Stahlsubstrat wurde eine a-CH:Si Beschichtung mittels PACVD unter Anwendung der voranstehend genannten Parameter hergestellt. Die Beschichtung hatte eine Härte 15 GPa, eine Schichtdicke von 23µm, eine arithmetischen Mittenrauwert Ra nach Beschichten von 0,85µm, und von 0,18µm nach Polieren. Es wurde damit eine Verringerung des Verschleißkoeffizienten am Gegenkörper um 2 Zehnerpotenzen erreicht, verglichen mit einem mit einer a-CH:Si Beschichtung auf einem Stahlsubstrat, das eine geringere Oberlfächenrauigkeit arithmetischen Mittenrauwert Ra kleiner als 0,5 µm) aufweist.

Die Ausführungsbeispiele zeigen bzw. beschreiben mögliche Ausführungsvarianten, wobei an dieser Stelle bemerkt sei, dass auch Kombinationen der einzelnen Ausführungsvarianten untereinander möglich sind

Der Ordnung halber sei abschließend darauf hingewiesen, dass zum besseren Verständnis des Aufbaus der Gegenstand 1 bzw. die Abscheidekammer 4 nicht zwingenderweise maßstäblich dargestellt sind.

### Bezugszeichenaufstellung

- 1: Gegenstand
- 2: Metalloberfläche
- 3: Hartstoffschicht
- 4: Abscheidekammer
- 5: Zufuhrleitung
- 6: Abfuhrleitung
- 7: Substrathalter
- 8: Oberflächenstruktur
- 9: Schichtdicke
- 10: Plateau
- 11: Tal
- 12: Substratschicht
- 13: Schichtdicke

## Patentansprüche

1. Verfahren zur Herstellung einer Hartstoffschicht (3) mit einer Härte gemäß DIN EN ISO 14577 von mindestens 3 GPa auf einer Metalloberfläche (2) eines Substrats mittels Gasphasenabscheidung, wobei die Metalloberfläche (2) vor der Abscheidung der Hartstoffschicht (3) zur Ausbildung einer Oberflächenstruktur (8) oberflächenbehandelt wird, sodass die Oberfläche nach der Oberflächenbehandlung eine Oberflächenrauigkeit nach DIN EN ISO 4287:2010-07 mit einem arithmetischen Mittenrauwert Ra zwischen 0,5 µm und 50 µm aufweist, **dadurch gekennzeichnet, dass** die Hartstoffschicht (3) mit einer Schichtdicke (9) hergestellt wird, die um mindestens 2,5 % größer ist als Ra der Metalloberfläche (2) und die Hartstoffschicht (3) nach der Abscheidung zur Reduktion der Oberflächenrauigkeit oberflächenbehandelt wird.

2. Verfahren nach Anspruch 1, **dadurch gekennzeichnet, dass** die Metalloberfläche (2) vor der Abscheidung der Hartstoffschicht (3) mit einer gemittelten Rautiefe Rz nach DIN EN ISO 4287:2010-07 zwischen 0,5 µm und 20 µm hergestellt wird und die Hartstoffschicht( 3) mit einer Schichtdicke (9) hergestellt wird, die um mindestens 5 % größer ist als Rz der Metalloberfläche (2).

3. Verfahren nach Anspruch 1 oder 2, **dadurch gekennzeichnet, dass** die Hartstoffschicht (3) mit einer Schichtdicke (9) von mindestens 10 µm hergestellt wird.

4. Verfahren nach einem der Ansprüche 1 bis 3, **dadurch gekennzeichnet, dass** die Hartstoffschicht (3) mit einer Schichtdicke (9) von maximal 200 µm hergestellt wird.

5. Verfahren nach einem der Ansprüche 1 bis 4, **dadurch gekennzeichnet, dass** als Hartstoffschicht (3) eine DLC Schicht, insbesondere eine a:C-H-Si - DLC Schicht, hergestellt wird.

6. Verfahren nach einem der Ansprüche 1 bis 5, **dadurch gekennzeichnet, dass** als Oberflächenbehandlung der Hartstoffschicht (3) nach der Abscheidung ein Schleifen, Polieren oder Strahlen durchgeführt wird.

7. Verfahren nach einem der Ansprüche 1 bis 6, **dadurch gekennzeichnet, dass** die Hartstoffschicht (3) durch die Oberflächenbehandlung mit einem arithmetischen Mittenrauwert Ra nach DIN EN ISO 4287:2010-07 zwischen 0,5 µm und 50 µm und/oder einer gemittelten Rautiefe Rz nach DIN EN ISO 4287:2010-07 zwischen 0,5 µm und 50 µm hergestellt wird.

8. Verfahren nach einem der Ansprüche 1 bis 7, **dadurch gekennzeichnet, dass** die Abscheidung der Hartstoffschicht (3) mittels eines PACVD-Verfahren durchgeführt wird.

9. Verfahren nach einem der Ansprüche 1 bis 8, **dadurch gekennzeichnet, dass** das Substrat vor der Abscheidung der Hartstoffschicht (3) nitriert wird.

10. Verfahren nach Anspruch 9, **dadurch gekennzeichnet, dass** die Nitrierung des Substrats bis zu einer Schichtdicke (12) zwischen 10 µm und 1000 µm durchgeführt wird, gemessen von der Metalloberfläche (2) beginnend.

11. Gegenstand (1) mit einer tribologische beanspruchten Oberfläche, die durch eine Hartstoffschicht (3) mit einer Härte gemäß DIN EN ISO 14577 von mindestens 3 GPa gebildet ist, wobei die Hartstoffschicht (3) auf einer Metalloberfläche (2) des Gegenstandes (1) angeordnet ist, die eine Oberflächenrauigkeit nach DIN EN ISO 4287:2010-07 mit einem arithmetischen Mittenrauwert Ra zwischen 0,5 µm und 50 µm aufweist, **dadurch gekennzeichnet, dass** die Hartstoffschicht (3) eine Schichtdicke (9) aufweist, die um mindestens 2 % größer ist als Ra, und die Hartstoffschicht (9) eine Oberflächenrauigkeit zur Ausbildung von Schmiermitteltaschen zur Aufnahme von Partikel aus dem Abrieb aufweist.

12. Gegenstand (1) nach Anspruch 11, **dadurch gekennzeichnet, dass** die Hartstoffschicht (3) eine Schichtdicke (9) von mindestens 10 µm aufweist.

13. Gegenstand (1) nach Anspruch 11 oder 12, **dadurch gekennzeichnet, dass** die Hartstoffschicht (3) eine Schichtdicke (9) von maximal 200 µm aufweist.

14. Gegenstand (1) nach einem der Ansprüche 11 bis 13, **dadurch gekennzeichnet, dass** die Hartstoffschicht (3) eine Oberflächenrauigkeit mit einem arithmetischen Mittenrauwert Ra nach DIN EN ISO 4287:2010-07 zwischen 0,5 µm und 50 µm und/oder einer gemittelten Rautiefe Rz nach DIN EN ISO 4287:2010-07 zwischen 0,5 µm und 50 µm aufweist.

15. Gegenstand (1) nach einem der Ansprüche 11 bis 14, **dadurch gekennzeichnet, dass** dieser ein Zahnrad, ein Kolbenring, eine Nockenwelle, ein Bolzen, eine Achse, eine Kolbenstange, ein Lager, ist.

16. Gegenstand (1) nach einem der Ansprüche 11 bis 15, **dadurch gekennzeichnet, dass** die Hartstoffschicht (3) einlagig ausgebildet ist.

17. Verwendung eines gemäß einem Verfahren nach einem der Ansprüche 1 bis 10 hergestellten Gegenstandes (1) in einer tribologisch beanspruchten Reibpaarung.
